# EUROPEAN PATENT APPLICATION

(11) **EP 4 776 010 A1**
(43) Date of publication of application: **15.07.2026**
(21) Application number: 25873886.3
(22) Date of filing: 01.07.2025
(51) Int. Cl.: G01R 31/389, G01R 31/385, G01R 31/392, G01R 23/02, G01R 27/08, G01R 19/10, G01R 23/00, G01R 25/00, G01R 29/02, G01R 31/367

(54) **APPARATUS FOR MANAGING BUSBAR FASTENING STATE OF BATTERY PACK AND WELDING STATE BETWEEN BATTERY CELLS, AND METHOD FOR INSPECTING BUSBAR FASTENING STATE OF BATTERY PACK AND WELDING STATE BETWEEN BATTERY CELLS**

(30) Priority: 24.09.2024 KR 20240128737
(71) Applicant: LG Energy Solution, Ltd., Seoul 07335 (KR)
(72) Inventor: HEO, Hwan, Daejeon 34122 (KR)
(74) Representative: Goddar, Heinz J.
(86) International application number: PCT/KR2025/009307
(87) International publication number: WO 2026/071409

(57) **Abstract**

The present invention relates to a management device for detecting poor busbar connection and defective inter-cell welding of a battery pack using electrochemical impedance spectroscopy (EIS) technology. The device of the present invention includes a measurement current generation unit that applies a set AC to a battery pack, a voltage measurement unit that measures a voltage generated across both ends of each battery cell or a busbar by the current, an impedance calculation unit that calculates an impedance using the measured current and voltage values, and a data output unit that generates a Nyquist or Bode plot based on the calculated impedance and outputs an impedance change.

## Description

### TECHNICAL FIELD

The present invention relates to a management device and an inspection method for a battery pack, and more particularly, to a management device and an inspection method for a battery pack for early detection of poor busbar connection and defective inter-battery cell welding using in-vehicle electrochemical impedance spectroscopy (EIS) technology.

### BACKGROUND ART

In small devices, individual battery cells are directly arranged, whereas, in vehicles and the like, battery modules in which a plurality of battery cells are electrically connected, and battery packs in which the battery modules are further connected, are used. The battery module is designed such that a plurality of battery cells are connected in series or parallel to output a voltage at or above a certain level, and a battery pack is designed such that a plurality of battery modules are connected via a connection member such as a busbar to provide higher output and capacity.

In this case, when a plurality of battery cells within the battery module are not properly connected due to poor assembly, the performance and stability of the battery module may deteriorate. In addition, since the battery pack is used in high-vibration environments, such as in automobiles, fastening screws of the busbar connecting the battery modules may loosen due to vibrations, which may degrade the performance and stability of the battery pack.

In addition, when an abnormal state such as poor busbar connection or defective inter-battery cell welding in the battery pack is not detected in advance, contact resistance may increase at the busbar, a connection part between battery cells, or the like, which may lead to electrical sparks or degradation, and thus battery cell failure or fire may occur, potentially leading to a serious accident. In fact, fires have been occurring frequently at the busbar connection parts within battery pack products in recent years, leading to electric vehicles being completely burned.

In order to solve the problem, after welding between battery cells and overlapping laser welding of busbars between battery modules, an inspection is conducted to guarantee the quality of the welding. The welding inspection is mainly conducted through visual/vision inspection to check the appearance of a weld bead including its depth, width, and penetration. However, the visual/vision inspection in the related art may only check the appearance of the weld bead including the depth, width, and penetration, but there is a problem in that abnormalities originating from issues inside base materials, such as the occurrence of a gap between base materials, insufficient depth, excessive internal porosity, or the like, may not be detected.

Meanwhile, a method for detecting reflected light/plasma using a photo diode or the like to identify an abnormal state during a welding process has been examined, but this has the problem that the reliability of the pass/fail detection is reduced due to the influence of external noise such as temperature, static electricity, radio waves, component tolerance, air blowers, and the like. That is, when a spec range is narrowed to minimize the influence of external noise, cases of over-detection occur frequently or cases where actual good products are determined as defective occur, which causes a decrease in a production line operating rate, and conversely, when the spec range is widened, cases of defective products leaking out may occur, resulting in a problem of a trade-off relationship in which quality competitiveness is reduced.

Due to these problems, in recent years, it has been made possible to measure a voltage of each battery cell through a battery management system (BMS) inside a vehicle and during driving, so that abnormal states of the battery pack (that is, poor welding, incorrect bolt assembly, and the like) may be detected. However, there is a problem that, when measuring a battery cell voltage with the BMS, it is very difficult to detect an abnormal state using only the voltage unless it is in a completely open state.

Examples of the related art include the following prior art documents
(Patent Document 1) Korean Patent Laid-Open Publication No. 10-2023-0034520 (published on March 10, 2023)
(Patent Document 2) Korean Patent Laid-Open Publication No. 10-2016-0123173 (published on October 25, 2016).

### DISCLOSURE OF THE INVENTION

### TECHNICAL PROBLEM

The present invention is directed to providing a management device and an inspection method for a battery pack for early detection of poor busbar connection and defective inter-battery cell welding using in-vehicle electrochemical impedance spectroscopy (EIS) technology.

The present invention is directed to providing a management device and an inspection method for a battery pack designed to prevent fire accidents by early detection of an abnormal condition of a battery pack, such as poor busbar connection, defective inter-battery cell welding, and the like.

The present invention is directed to providing a management device and an inspection method for a battery pack for detecting an abnormal condition of a battery pack based on an impedance change calculated using current and voltage values measured across both ends of battery packs connected by a busbar.

### TECHNICAL SOLUTION

In accordance with an exemplary embodiment, a management device of a battery pack includes a measurement current generation unit configured to generate a measurement current that is an alternating current (AC) having a set measurement frequency and apply the measurement current to a (+) output terminal and a (-) output terminal of the battery pack, a voltage measurement unit configured to measure a voltage generated either across both terminals of an arbitrary battery cell among a plurality of battery cells within the battery pack or across both ends of a busbar by the measurement current applied to the (+) output terminal and the (-) output terminal of the battery pack, an impedance calculation unit configured to calculate an impedance using a measurement current value generated by the measurement current generation unit and a voltage value measured by the voltage measurement unit, and a data output unit configured to output an impedance change of the busbar or an impedance change of the battery cells within the battery pack based on the calculated impedance.

The measurement current generation unit may connect a first current applying electrode ((-)Forcing) and a second current applying electrode ((+)Forcing) to battery cells located at both ends of the battery pack, respectively, and apply the generated measurement current to the battery cells.

The measurement current generation unit may generate two or more ACs having different measurement frequencies as measurement currents.

A signal amplitude of the measurement current may be set to produce an amplitude signal of 5 mV to 10 mV.

The data output unit may further include a defect detection unit configured to detect a poor contact of the busbar from the impedance change of the busbar, or detect a poor contact between battery cells from the impedance change the battery cells within the battery pack.

The voltage measurement unit may connect a first voltage measuring electrode ((-)Sensing) and a second voltage measuring electrode ((+)Sensing) either to both terminals of the arbitrary battery cell or to both ends of the busbar, respectively, and measure the voltage across the connected terminals or ends.

The impedance calculation unit may calculate the impedance using a phase difference and magnitude between a measurement current and a measurement voltage, or a ratio between the measurement current and the measurement voltage.

The impedance may a busbar impedance calculated from the busbar when the measured voltage value is a voltage across both ends of the busbar, and may be a battery cell impedance of the arbitrary battery cell when the measured voltage value is a voltage across both terminals of the arbitrary battery cell.

The data output unit may show a real part and an imaginary part of the impedance in the Nyquist plot and show an impedance magnitude and phase angle versus frequency in the Bode plot.

The impedance calculation unit and the data output unit may be provided in a signal processing unit (DSP) separate from a micro-controller unit (MCU) of a battery management device.

In accordance with an exemplary embodiment, a method for inspecting a battery pack includes generating, by a measurement current generation unit, an AC having a set measurement frequency as a measurement current, and applying the measurement current to a (+) output terminal and a (-) output terminal of the battery pack, measuring, by a voltage measurement unit, a voltage generated either across both terminals of an arbitrary battery cell within the battery pack or across both ends of a busbar by the measurement current applied to the (+) output terminal and the (-) output terminal of the battery pack, calculating, by an impedance calculation unit, an impedance using a generated current value and a measured voltage value, and outputting, by a data output unit, an impedance change of the busbar or an impedance change of the battery cells within the battery pack based on the calculated impedance.

The method may further include, prior to the applying of the measurement current, applying a current to terminals of the battery pack by connecting a first current applying electrode ((-)Forcing) and a second current applying electrode ((+)Forcing) to the (+) output terminal and the (-) output terminal of the battery pack, respectively, and connecting electrodes for voltage measurement by connecting a first voltage measuring electrode ((-)Sensing) and a second voltage measuring electrode ((+)Sensing) either to both terminals of the arbitrary battery cell within the battery pack or to both ends of the busbar, respectively.

In the connecting of the electrodes for voltage measurement, the first voltage measuring electrode ((-)Sensing) and the second voltage measuring electrode ((+)Sensing) may be connected to both ends of the busbar, respectively, in a case of inspecting a poor busbar connection, and each of the first voltage measuring electrode ((-)Sensing) and the second voltage measuring electrode ((+)Sensing) may be connected to the arbitrary battery cell among the plurality of battery cells located within the battery pack in a case of detecting a defective inter-battery cell welding.

The impedance may be calculated using a phase difference and magnitude between a measurement current and a measurement voltage, or a ratio between the measurement current and the measurement voltage.

The measurement current may be two or more ACs having different measurement frequencies.

The outputting of the impedance change may further include analyzing the impedance change through a visualized Nyquist or Bode plot to evaluate electrochemical characteristics and performance of the busbar or the battery cell, and detecting an abnormal state including a poor busbar connection and a defective inter-battery cell welding.

A real part and an imaginary part of the impedance may be shown in the Nyquist plot and an impedance magnitude and phase angle versus frequency may be shown in the Bode plot.

### ADVANTAGEOUS EFFECTS

According to an embodiment of the present invention, it is possible to prevent a fire accident by early detection of an abnormal condition in a battery pack, such as poor busbar connection and defective inter-battery cell welding.

According to an embodiment of the present invention, by detecting an impedance change calculated using current and voltage values measured across both ends of battery packs connected by a busbar, it is possible to very rapidly diagnose an internal state of the battery pack, thereby providing performance and stability of the battery pack.

### BRIEF DESCRIPTION OF THE DRAWINGS

FIG. 1(a) and FIG. 1(b) are diagrams illustrating a configuration of a management device for states of busbar connection and welding between battery cells of a battery pack according to an embodiment of the present invention;
FIG. 2 is a diagram illustrating components of the management device in FIG. 1(a) and FIG. 1(b) in detail; and
FIG. 3 is a flowchart for describing an inspection method for states of busbar connection and welding between battery cells of a battery pack according to an embodiment of the present invention.

### MODE FOR CARRYING OUT THE INVENTION

Hereinafter, exemplary embodiments of the present invention will be described in detail with reference to the accompanying drawings. However, the present invention is not limited to the exemplary embodiments disclosed below, but will be implemented in a variety of different forms. The exemplary embodiments of the present invention are only provided to allow the present invention to be complete, and to completely inform those skilled in the art of the scope of the disclosure. The drawings may be exaggerated to describe the disclosure in detail, and like reference numerals refer to like elements in the drawings.

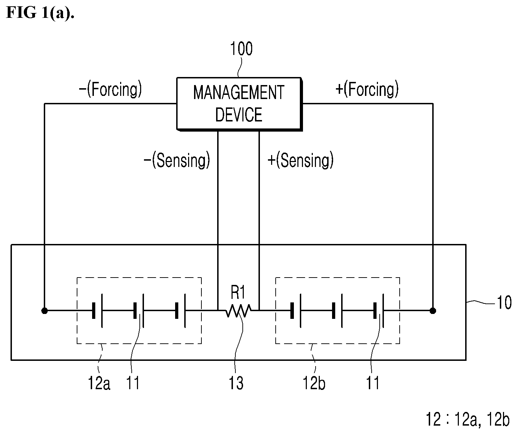

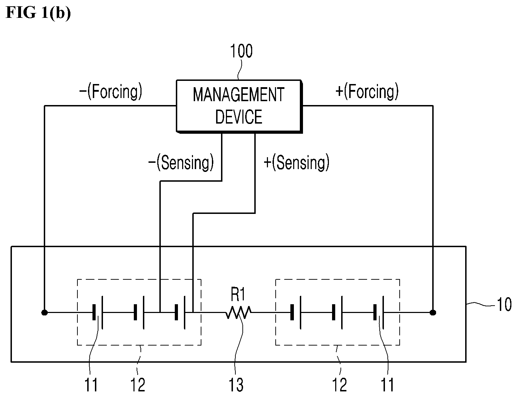

FIG. 1(a) and FIG. 1(b) are diagrams illustrating a configuration of a management device for states of busbar connection and welding between battery cells of a battery pack according to an embodiment of the present invention. In this case, FIG. 1(a) shows a configuration for detecting a poor busbar connection, and FIG. 1(b) shows a configuration for detecting a defective inter-battery cell welding.

Referring to FIG. 1(a) and FIG. 1(b), a management device 100 of a battery pack according to an embodiment of the present invention detects an abnormal condition of the battery pack based on an impedance change calculated using a current value and a voltage value measured in a battery pack 10 in which a plurality of battery modules 12 are connected by a busbar 13.

In the battery pack 10, a plurality of battery cells 11 constitute one battery module 12, and a first battery module 12a and a second battery module 12b are connected via the busbar 13. In this case, in the drawing, the battery module 12 is constituted by three battery cells 11 connected in series, but is not limited thereto, and may be constituted by three battery cells or more or three battery cells or less that are connected in series or in parallel. In addition, when a plurality of busbars 13 are provided, a pair of battery modules 12 connected thereto may be arranged in series or in parallel using two or more units corresponding to the number of busbars 13.

The battery cell 11 may be set to a specific state when necessary for the experiment. For example, the battery cell 11 may be set to a charging or discharging state. In addition, the battery cell 11 may be installed in an appropriate location when a reference electrode and an auxiliary electrode are required.

The management device 100 may be an electrochemical impedance spectroscopy (EIS) device.

The management device 100 of the battery pack connects electrodes to the battery cells 11. The electrodes may be two electrodes, a working electrode (RE) and a counter electrode (CE), or three electrodes, a working electrode (RE), a counter electrode (CE), and a reference electrode (WE).

The management device 100 of the battery pack connects a current applying electrode (Forcing) to both ends of the battery cells 11 and connects a voltage measuring electrode (Sensing) either to both terminals of an arbitrary battery cell 11 or to both ends of the busbar 13. In addition, by applying a measurement current, which is an alternating current (AC), to the battery cells 11 within a frequency range of a set measurement frequency, the impedance of an arbitrary battery cell 11 or the busbar 13 is measured. The management device 100 may record the measured impedance data according to the set measurement frequency and output the data as a Nyquist or Bode plot for visualization. As an example, the frequency range is set from 1 mHz to 1 MHz, and a signal amplitude is set to produce a small signal from 5 mV to 10 mV. In addition, a measurement potential is set to match a potential of the battery cell 11.

The management device 100 of the battery pack may analyze the impedance change of the busbar 13 or the battery cell 11 based on the measured impedance through the output Nyquist or Bode plot and evaluate the internal resistance, ion mobility, interfacial characteristics, and the like of the battery pack 10. In this case, the Nyquist plot may show a real part and an imaginary part of the impedance, and the Bode plot may show the impedance magnitude and phase angle versus frequency, through which the electrochemical characteristics of the battery pack 10 may be interpreted.

As illustrated in FIG. 1(a), the management device 100 of the battery pack connects a first current applying electrode ((-)Forcing) and a second current applying electrode ((+)Forcing) to the battery cells 11 located at both ends, respectively, and a first voltage measuring electrode ((-)Sensing) and a second voltage measuring electrode ((+)Sensing) to both ends of the busbar 13, respectively, to detect a poor connection of the busbar 13.

The management device 100 of the battery pack applies a measurement current, which is an AC, to the battery cells 11 within the set frequency range through the current applying electrodes (Forcing) and measures the voltage generated across both ends of the busbar 13 by a measurement current applied through the voltage measuring electrodes (Sensing). In this case, the applied current is stored. In addition, the management device 100 calculates the impedance using data on the measured voltage and current. In this case, the impedance is a value measured at an R1 portion of the busbar 13, and is calculated by measuring the voltage change due to the current passing through the entire battery pack 10, and the impedance is calculated using a phase difference and magnitude between a measurement current and a measurement voltage, or a ratio between the measurement current and the measurement voltage.

The management device 100 of the battery pack may analyze the impedance change of the busbar 13 versus frequency based on the calculated impedance, and in this way, may evaluate the electrochemical characteristics and performance of the busbar 13, thereby detecting a poor connection of the busbar 13.

In addition, as illustrated in FIG. 1(b), the management device 100 of the battery pack connects the first current applying electrode ((-)Forcing) and the second current applying electrode ((+)Forcing) to the battery cells 11 located at both ends, respectively, and connects the first voltage measuring electrode ((-)Sensing) and the second voltage measuring electrode ((+)Sensing) to both terminals of an arbitrary battery cell 11 among a plurality of battery cells located inside the battery pack 10, respectively, to detect a defective welding between the battery cells 11. In this case, the arbitrary battery cell 11 connected to the first voltage measuring electrode ((-)Sensing) and the second voltage measuring electrode ((+)Sensing) may be a battery cell 11 selected to detect a defective welding.

The management device 100 of the battery pack applies a measurement current, which is an AC, to the battery cells 11 within the set frequency range through the current applying electrodes (Forcing) and measures the voltage generated across both terminals of the battery cell 11 by a measurement current applied through the voltage measuring electrodes (Sensing). The voltage measured at this time is a voltage that appears as a reaction to the applied measurement current. In this case, the applied current is stored.

In addition, the management device 100 of the battery pack calculates the impedance using data on the measured voltage and current. In this case, the impedance is calculated using the phase difference and magnitude between the measurement current and the measurement voltage, or the ratio between the measurement current and the measurement voltage.

The management device 100 of the battery pack may analyze the impedance change of the battery cell 11 versus frequency based on the calculated impedance. In this case, in a low frequency range (from about 0.1 Hz or less to several Hz (e.g., 0.1 Hz to 10 Hz)), mainly the total resistance and capacity component of the battery cell 11 may be measured, and in a high frequency range (several kHz or more (e.g., 1 kHz to 1 MHz)), mainly the electric double layer effect and the intrinsic resistance inside the battery cell 11 may be measured. In addition, in an intermediate frequency range (e.g., 10 Hz to 1 kHz), the charge transfer resistance and intermediate rate electrochemical reactions of the battery cell 11 may be measured.

In this way, the electrochemical characteristics and performance of the battery cell 11 may be evaluated, and the defective welding between the battery cells 11 may be detected.

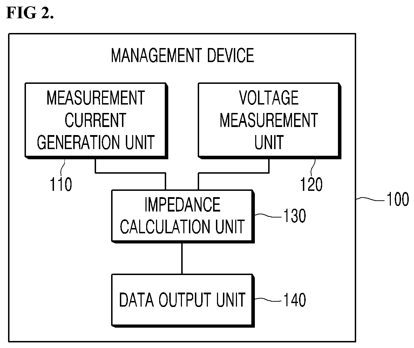

FIG. 2 is a diagram illustrating components of the management device in FIG. 1(a) and FIG. 1(b) in detail.

Referring to FIG. 2, a management device 100 of a battery pack according to an embodiment of the present invention includes a measurement current generation unit 110, a voltage measurement unit 120, an impedance calculation unit 130, and a data output unit 140.

The measurement current generation unit 110 generates a measurement current, which is an AC having a predetermined measurement frequency, and applies the AC to a (+) output terminal and a (-) output terminal of the battery pack 10. To this end, the measurement current generation unit 110 connects the first current applying electrode ((-)Forcing) and the second current applying electrode ((+)Forcing) to the battery cells 11 located at both ends of the battery pack 10, respectively, and applies the generated measurement current to the battery cells 11.

For the measurement frequency, the frequency range is set from 1 mHz to 1 MHz, and a signal amplitude is set to produce a small amplitude signal from 5 mV to 10 mV. In addition, the measurement potential is set to match the potential of the battery cell 11. In this case, the measurement frequency may be divided into a low frequency range having a frequency range from about 0.1 Hz or less to several Hz (e.g., 0.1 Hz to 10 Hz), a high frequency range having a frequency range of several kHz or more (e.g., 1 kHz to 1 MHz), and an intermediate frequency range having a frequency range from several Hz to several kHz (e.g., 10 Hz to 1 kHz).

In the low frequency range, the overall resistance and capacity components of the battery pack 10 may be measured. The impedance at low frequencies is related to the electrochemical reactions, charge/discharge processes, and diffusion processes inside the battery pack 10. Therefore, the low frequency range is useful when analyzing the overall electrochemical characteristics of the battery pack 10. In addition, in the high frequency range, mainly the electric double layer effect and the intrinsic resistance inside the battery cell 11 may be measured. The impedance at high frequencies is mainly related to the electric double layer capacity and internal resistance at an electrode-electrolyte interface of the battery cell 11. Therefore, the high frequency range is useful when analyzing the internal resistance and fast response characteristics of the battery cell 11. In addition, in the intermediate frequency range, the charge transfer resistance and intermediate rate electrochemical reactions of the battery cell 11 may be analyzed.

These frequency ranges may have a slight difference depending on the type and condition of the battery pack 10, and the frequency range of the set measurement frequency is appropriately set depending on the characteristic to be measured or the abnormal state of the battery pack 10 (that is, poor busbar connection, defective inter-battery cell welding, and the like).

The voltage measurement unit 120 measures the voltage generated either at both terminals of an arbitrary battery cell 11 among the plurality of battery cells within the battery pack 10 or at both ends of the busbar 13 by the measurement current applied to the (+) output terminal and the (-) output terminal of the battery pack 10. To this end, the voltage measurement unit 120 connects the first voltage measuring electrode ((-)Sensing) and the second voltage measuring electrode ((+)Sensing) either to both terminals of the arbitrary battery cell 11 or to both ends of the busbar 13, respectively, and measures the voltage across the connected terminals or ends.

That is, as illustrated in FIG. 1(a), the voltage measurement unit 120 connects the first voltage measuring electrode ((-)Sensing) and the second voltage measuring electrode ((+)Sensing) to both ends of the busbar 13, respectively, and measures the voltage across both ends of the busbar 13. Alternatively, as illustrated in FIG. 1(b), the first voltage measuring electrode ((-)Sensing) and the second voltage measuring electrode ((+)Sensing) are connected to both terminals of the arbitrary battery cell 11, respectively, and measure the voltage across both terminals of the battery cell 11.

The impedance calculation unit 130 calculates an impedance using a current value generated by the measurement current generation unit 110 and a voltage value measured by the voltage measurement unit 120. In this case, the impedance is calculated using the phase difference and magnitude between the measurement current and the measurement voltage, or the ratio between the measurement current and the measurement voltage.

In this case, when the measured voltage value is the voltage across both ends of the busbar 13, the impedance calculated by the impedance calculation unit 130 is a value measured at the R1 portion of the busbar 13, and is the impedance of the busbar 13. In addition, when the measured voltage value is a voltage across both terminals of the arbitrary battery cell 11, the impedance calculated by the impedance calculation unit 130 is the value measured across the arbitrary battery cell 11, and is the impedance of the battery cell 11.

The data output unit 140 generates a Nyquist or Bode plot based on the calculated impedance, and outputs the impedance change of the busbar 13 or the battery cells 11 within the battery pack 10. In this way, the impedance change is analyzed and the electrochemical characteristics and performance of the busbar 13 or the battery cell 11 are evaluated, so that an abnormal state such as poor busbar connection and defective inter-battery cell welding is detected. In this case, the Nyquist plot may show a real part and an imaginary part of the impedance, and the Bode plot may show the impedance magnitude and phase angle versus frequency, through which the electrochemical characteristics of the battery pack 10 may be interpreted.

As described above, the impedance change of the busbar 13 or the battery cell 11 may be analyzed based on the measured impedance through the output Nyquist or Bode plot and the internal resistance, ion mobility, interfacial characteristics, and the like of the battery pack 10 may be evaluated, so that an abnormal state of the battery pack 10 (that is, as poor busbar connection, defective inter-battery cell welding, and the like) is detected.

To this end, the data output unit 140 may further include a defect detection unit (not illustrated) that detects a poor contact of the busbar 13 or a poor contact between battery cells 11 from the impedance change of the busbar 13 or the battery cells 11 within the battery pack 10. During EIS measurement, when a value different from the impedance corresponding to each cell is measured for a cell or a value different from the normal impedance of the busbar is detected, the defect detection unit detects a poor contact of the busbar or a poor contact of the battery cell or between the battery cells.

In this case, the management device 100 of the battery pack may detect the impedance change of the busbar 13 or the battery cells 11 within the battery pack 10, so that early detection is possible in the event of an abnormal state, such as a poor busbar connection, defective inter-battery cell welding, and the like.

Meanwhile, the data output unit 140 may vary characteristics analyzed through impedance depending on a frequency region of the measurement frequency set to generate the measurement current.

That is, the data output unit 140 may mainly measure the total resistance and capacity components of the battery pack 10 in a low frequency region (e.g., 0.1 Hz to 10 Hz). The impedance at low frequencies is related to the electrochemical reactions, charge/discharge processes, and diffusion processes inside the battery pack 10. Therefore, the low frequency region is useful when analyzing the overall electrochemical characteristics of the battery pack 10. In addition, the data output unit 140 may mainly measure the electric double layer effect and the intrinsic resistance inside the battery cell 11 in a high frequency region (e.g., 1 kHz to 1 MHz). The impedance at high frequencies is mainly related to the electric double layer capacity and internal resistance at an electrode-electrolyte interface of the battery cell 11. Therefore, the high frequency region is useful when analyzing the internal resistance and fast response characteristics of the battery cell 11. In addition, the data output unit 140 may analyze the charge transfer resistance and intermediate-rate electrochemical reactions of the battery cell 11 in an intermediate frequency region (e.g., 10 Hz to 1 kHz).

Hereinafter, an inspection method for states of busbar connection and welding between battery cells of a battery pack according to an embodiment of the present invention will be described. The inspection method for states of busbar connection and welding between battery cells of a battery pack according to an embodiment of the present invention may be a method for processing a signal received using the above-described management device for states of busbar connection and welding between battery cells of the battery pack, and accordingly, the contents described in the management device for states of busbar connection and welding between battery cells of the battery pack is equally applicable here, and therefore, a repeated description thereof may be omitted.

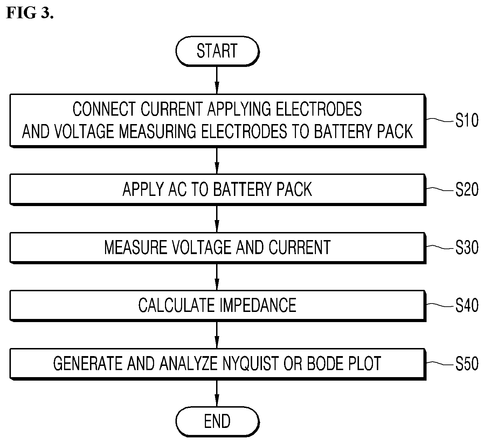

FIG. 3 is a flowchart for describing an inspection method for states of busbar connection and welding between battery cells of a battery pack according to an embodiment of the present invention.

Referring to FIG. 3, in a method for inspecting a battery pack according to an embodiment of the present invention, first, a first current applying electrode ((-)Forcing) and a second current applying electrode ((+)Forcing) are connected to the (+) output terminal and the (-) output terminal of the battery pack 10, respectively, and a first voltage measuring electrode ((-)Sensing) and a second voltage measuring electrode ((+)Sensing) are connected either to both terminals of an arbitrary battery cell 11 among a plurality of battery cells within the battery pack 10 or to both ends of the busbar 13, respectively (S10).

In this case, the first voltage measuring electrode ((-)Sensing) and the second voltage measuring electrode ((+)Sensing) are connected to both ends of the busbar 13, respectively, in a case of inspecting a poor connection of the busbar 13, and each of the first voltage measuring electrode ((-)Sensing) and the second voltage measuring electrode ((+)Sensing) is connected to the arbitrary battery cell 11 located within the battery pack 10 in a case of detecting a defective welding between the battery cells 11.

Subsequently, in the measurement current generation unit 110, a measurement current having a preset measurement frequency is generated, and the measurement current is applied to the (+) output terminal and the (-) output terminal of the battery pack 10 through the first current applying electrode ((-)Forcing) and the second current applying electrode ((+)Forcing) (S20).

In this case, for the measurement frequency, the frequency range is set from 1 mHz to 1 MHz, and a signal amplitude is set to produce a small amplitude signal from 5 mV to 10 mV. In addition, the measurement potential is set to match the potential of the battery cell 11. These frequency ranges may have a slight difference depending on the type and condition of the battery pack 10, and the frequency range of the set measurement frequency may be appropriately set depending on the characteristic to be measured or the abnormal state of the battery pack 10 (that is, poor busbar connection, defective inter-battery cell welding, and the like).

Subsequently, in the voltage measurement unit 120, the voltage generated either at both terminals of the arbitrary battery cells 11 among the plurality of battery cells within the battery pack 10 or at both ends of the busbar 13 by the measurement current applied to the (+) output terminal and the (-) output terminal of the battery pack 10 is measured using the first voltage measuring electrode ((-)Sensing) and the second voltage measuring electrode ((+)Sensing) (S30).

In this case, the voltage measurement unit 120 measures the voltage of the busbar 13 in the case of inspecting a poor connection of the busbar 13, and measures the voltage of the battery cell 11 in the case of detecting a defective welding between the battery cells 11.

Subsequently, in the impedance calculation unit 130, the generated current value and the measured voltage value are used to calculate an impedance (S40).

In this case, when the measured voltage value is the voltage of the busbar 13, the value measured at the R1 portion of the busbar 13 is the impedance of the busbar 13, and when the measured voltage value is the voltage of the battery cell 11, the value measured at the arbitrary battery cell 11 is the impedance of the battery cell 11. The impedance may be calculated using the phase difference and magnitude between the measurement current and the measurement voltage, or the ratio between the measurement current and the measurement voltage.

Subsequently, in the data output unit 140, a Nyquist or Bode plot is generated based on the calculated impedance, thereby visualizing the impedance change of the busbar 13 or the battery cells 11 within the battery pack 10 (S50).

In this way, the impedance change is analyzed and the electrochemical characteristics and performance of the busbar 13 or the battery cell 11 are evaluated, so that an abnormal state such as poor busbar connection and defective inter-battery cell welding is detected.

Meanwhile, the management device 100 of the battery pack is constructed in the BMS, the impedance change of the busbar 13 or the battery cells 11 may be detected within the battery pack 10, so that early detection is possible in the event of an abnormal state, such as a poor busbar connection, defective inter-battery cell welding, and the like.

In the above, although preferred embodiments of the present invention have been described and illustrated using specific terms, such terms are only used to clearly describe the present invention, and it is obvious that various modifications and changes can be made to the exemplary embodiments of the present invention and the described terms without departing from the spirit and scope of the present invention as defined by the following claims and their equivalents. Such modified embodiments should not be individually understood from the spirit and scope of the present invention, and should be construed as falling within the scope of the claims of the present invention.

The names of symbols used in the detailed description of the present invention and each drawing are as follows.

| | | | |
|---|---|---|---|
| 10: | Battery pack | 11: | Battery cell |
| 12: | Battery module | 13: | Busbar |
| 100: | Management device of battery pack | 110: | Measurement current generation unit |
| 120: | Voltage measurement unit | 130: | Impedance calculation unit |
| 140: | Data output unit | | |

## Claims

1. A management device of a battery pack, comprising:
a measurement current generation unit configured to generate a measurement current that is an alternating current AC having a set measurement frequency and apply the measurement current to a + output terminal and a - output terminal of the battery pack;
a voltage measurement unit configured to measure a voltage generated either across both terminals of an arbitrary battery cell among a plurality of battery cells within the battery pack or across both ends of a busbar by the measurement current applied to the + output terminal and the - output terminal of the battery pack;
an impedance calculation unit configured to calculate an impedance using a measurement current value generated by the measurement current generation unit and a voltage value measured by the voltage measurement unit; and
a data output unit configured to output an impedance change of the busbar or an impedance change of the battery cells within the battery pack based on the calculated impedance.

2. The management device of claim 1, wherein the measurement current generation unit connects a first current applying electrode and a second current applying electrode to battery cells located at both ends of the battery pack, respectively, and applies the generated measurement current to the battery cells.

3. The management device of claim 1 or 2, wherein the measurement current generation unit generates two or more ACs having different measurement frequencies as the measurement currents.

4. The management device of claim 3, wherein a signal amplitude of the measurement current is set to produce an amplitude signal of 5 mV to 10 mV.

5. The management device of claim 3, wherein the data output unit further includes a defect detection unit configured to detect a poor contact of the busbar from the impedance change of the busbar, or detect a poor contact between battery cells from the impedance change of the battery cells within the battery pack.

6. The management device of claim 1, wherein the voltage measurement unit connects a first voltage measuring electrode and a second voltage measuring electrode either to both terminals of the arbitrary battery cell or to both ends of the busbar, respectively, and measures the voltage across the connected terminals or ends.

7. The management device of claim 1, wherein the impedance calculation unit calculates the impedance using a phase difference and magnitude between the measurement current and a measurement voltage, or a ratio between the measurement current and the measurement voltage.

8. The management device of claim 1, wherein the impedance calculated in the impedance calculation unit is a busbar impedance calculated from the busbar when the measured voltage value is a voltage across both ends of the busbar, and is a battery cell impedance of the arbitrary battery cell when the measured voltage value is a voltage across both terminals of the arbitrary battery cell.

9. The management device of claim 1, wherein the data output unit analyzes electrochemical characteristics of the battery pack through a real part and an imaginary part of the impedance shown in a Nyquist plot and an impedance magnitude and phase angle versus frequency shown in a Bode plot.

10. The management device of claim 1, wherein the impedance calculation unit and the data output unit are provided in a signal processing unit DSP separate from a micro-controller unit MCU of a battery management device.

11. A method for inspecting a battery pack, comprising:
generating, by a measurement current generation unit, an alternating current AC having a set measurement frequency as a measurement current, and applying the measurement current to a + output terminal and a - output terminal of the battery pack;
measuring, by a voltage measurement unit, a voltage generated either across both terminals of an arbitrary battery cell among a plurality of battery cells within the battery pack or across both ends of a busbar by the measurement current applied to the + output terminal and the - output terminal of the battery pack;
calculating, by an impedance calculation unit, an impedance using a generated current value and a measured voltage value; and
outputting, by a data output unit, an impedance change of the busbar or an impedance change of the battery cells within the battery pack based on the calculated impedance.

12. The method of claim 11, further comprising, prior to the applying of the measurement current:
applying a current to terminals of the battery pack by connecting a first current applying electrode and a second current applying electrode to the + output terminal and the - output terminal of the battery pack, respectively; and
connecting electrodes for voltage measurement by connecting a first voltage measuring electrode and a second voltage measuring electrode either to both terminals of the arbitrary battery cell within the battery pack or to both ends of the busbar, respectively.

13. The method of claim 12, wherein in the connecting of the electrodes for voltage measurement, the first voltage measuring electrode and the second voltage measuring electrode are connected to both ends of the busbar, respectively, in a case of inspecting a poor busbar connection, and each of the first voltage measuring electrode and the second voltage measuring electrode is connected to the arbitrary battery cell located within the battery pack in a case of detecting a defective inter-battery cell welding.

14. The method of claim 11, wherein the impedance is calculated using a phase difference and magnitude between the measurement current and a measurement voltage, or a ratio between the measurement current and the measurement voltage.

15. The method of claim 11 or 14, wherein the measurement current is two or more ACs having different measurement frequencies.

16. The method of claim 11, wherein the outputting of the impedance change further includes analyzing the impedance change through a visualized Nyquist plot or Bode plot to evaluate electrochemical characteristics and performance of the busbar or the battery cell, and detecting an abnormal state including a poor busbar connection and a defective inter-battery cell welding.

17. The method of claim 16, wherein a real part and an imaginary part of the impedance are shown in the Nyquist plot and an impedance magnitude and phase angle versus frequency are shown in the Bode plot.
